Europäisches Patentamt

European Patent Office

Office européen des brevets

(19)

(11) Veröffentlichungsnummer : **0 171 723**
**B1**

(12) **EUROPÄISCHE PATENTSCHRIFT**

(45) Veröffentlichungstag der Patentschrift :
05.04.89

(21) Anmeldenummer : 85109750.1

(22) Anmeldetag : 02.08.85

(51) Int. Cl.⁴ : **H 03 F  1/52**

(54) Überlastungsschutzschaltung für einen Niederfrequenzverstärker.

(30) Priorität : 11.08.84 DE 3429701

(43) Veröffentlichungstag der Anmeldung :
19.02.86 Patentblatt 86/08

(45) Bekanntmachung des Hinweises auf die Patenterteilung : 05.04.89 Patentblatt 89/14

(84) Benannte Vertragsstaaten :
**AT CH DE FR GB LI NL**

(56) Entgegenhaltungen :
DE--A-- 3 200 112
GB--A-- 2 037 112
GB--A-- 2 069 272
US--A-- 3 818 366
US--A-- 3 976 955
**GRUNDIG TECHNISCHE INFORMATIONEN, Band 1/2,
1980, Seiten 45-57; G. AUER u.a.: "Die Endstufe des V
5000"**

(73) Patentinhaber : **Deutsche Thomson-Brandt GmbH
Postfach 1307
D-7730 Villingen-Schwenningen (DE)**

(72) Erfinder : **Sternad, Rolf
Breslauerstrasse 11
D-7730 Villingen-Schwenningen (DE)**

**Beschreibung**

Die Erfindung geht aus von einer Überlastungsschutzschaltung für einen Niederfrequenzverstärker, wie sie im Oberbegriff des Patentanspruchs 1 angegeben ist.

Galvanisch gekoppelte Niederfrequenzverstärker in Gegentaktschaltung werden mit zwei gleichgroßen in Bezug auf das Chassiepotential entgegengesetzt gepolten Versorgungsspannungen betrieben. Dabei sind die zueinander komplementären Endstufentransistoren derart symmetriert, daß sie gleichgroße Ströme aufnehmen, so daß an dem beiden Endstufentransistoren gemeinsamen Ausgangsanschluß in Bezug auf das Chassis keine Gleichspannung steht. Die am Ausgang angeschaltete Lastimpedanz wird nur von dem verstärkten Signalwechselstrom durchflossen. Treten Störungen infolge eines Defektes eines Bauteils des Niederfrequenzverstärkers auf, wodurch die Symmetrie der Schaltung verlorengeht, oder wird die Lastimpedanz über einen bestimmten Betrag vermindert bis hin zum Kurzschluß am Ausgang, tritt die Gefahr unzulässiger Erwärmung des Verstärkers und auch des Netzteils auf. Die Sicherheitsvorschriften von z. B. IEC oder VDE verlangen, daß im Fall eines Defektes irgend eines Bauteils keinerlei unzulässige Erwärmung des Gerätes auftreten darf. Bei derartigen Störungen kann z. B. der angeschlossene Lautsprecher zerstört werden oder das Netzteil des Gerätes wird übermässig erwärmt, wodurch eine erhöhte Brandgefahr hervorgerufen wird.

Bisher bekannte Schaltungen vermindern diese Gefahr im Störfall dadurch, daß bei Auftreten einer Gleichspannung am Ausgang ein Relais aktiviert wird, welches die angeschlossenen Lautsprecher am Ausgang abschaltet (Grundig Technische Informationen Heft 1/2 1980, S. 55/56). Ein solches Relais ist jedoch ein mechanisches Bauteil, welches die Kosten eines Gerätes erhöht. Auch sind Schutzschaltungen bekannt, die bei zu kleinen Lastimpedanzen bzw. beim Kurzschluß am Ausgang des Verstärkers mittels eines im Netztransformator angebrachten Temperaturfühlers das Gerät abschalten (a.a.O.). Diese Arten der Abschaltung sind jedoch oftmals nicht schnell genug, so daß es zur Zerstörung der Endstufe kommen kann. Aus der DE-A-32 00 112 geht eine Schutzschaltung hervor, die die Versorgungsspannungen der Endstufe abschaltet. Aus der GB-A-2 069 272 schließlich geht eine Schaltung hervor, die die Versorgungsspannung der Eingangsstufe über eine Sensorschaltung im Störfall abschaltet.

Der Erfindung liegt die Aufgabe zugrunde, bei einem Niederfrequenzverstärker mit einer Eingangsstufe, einer Vortreiberstufe im A-Betrieb, einer dieser unmittelbar nachgeschalteten Treiber- und einer Endstufe diesen Niederfrequenzverstärker bei Störungen in kürzester Zeit abzuschalten. Diese Aufgabe wird durch die im Patentanspruch 1 angegebene Erfindung gelöst. Weitere Ausgestaltungen der Erfindung ergeben sich aus den Unteransprüchen.

Die Erfindung besitzt den Vorteil, daß sie sehr zuverlässig arbeitet, wobei der zusätzliche Schaltungsaufwand nicht sehr hoch und damit kostengünstig ist.

Nachstehend sei an einem Ausführungsbeispiel das Wesentliche der Erfindung beschrieben.

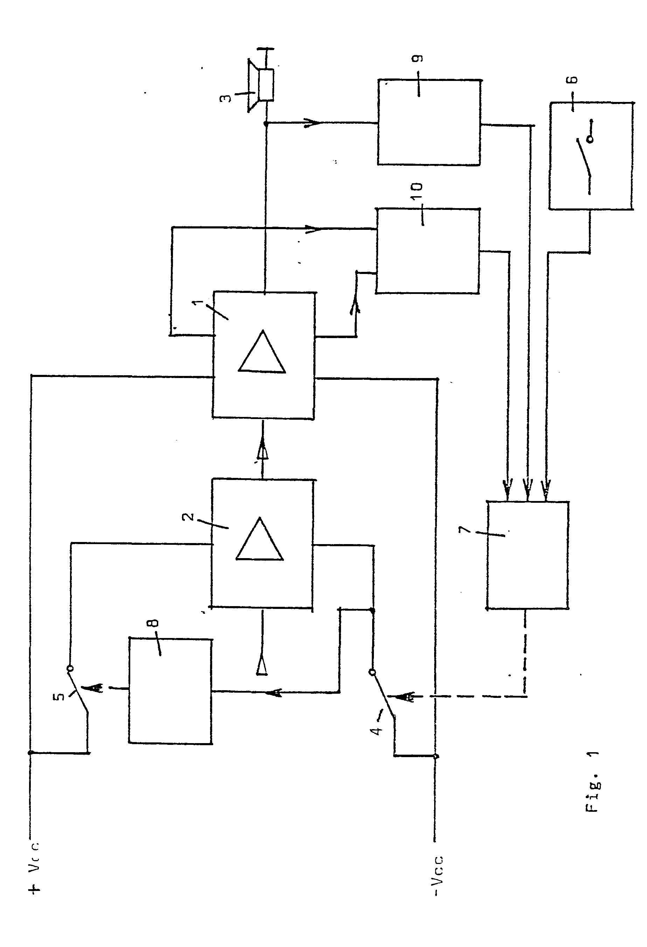

Figur 1 zeigt ein Blockschaltbild der Erfindung zur Darstellung der prinzipiellen Wirkungsweise,

Figur 2 zeigt ein ausführliches Schaltbild.

Mit 1 ist die Endstufe eines Niederfrequenzverstärkers bezeichnet, die von einer Vortreiberstufe 2 angesteuert wird. Die Endstufe 1 wird von dersymmetrischen Versorgungsspannungsquelle ± VCC gespeist. An die Endstufe 1 ist ein Lautsprecher 3 angeschaltet. Die Vortreiberstufe 2 ist mit den Polen + VCC und — VCC der Versorgungsspannungsquelle über Schalter 4 und 5 Verbindbar und wieder abschaltbar. Eine Anlaufschaltung 6 steuert bei Inbetriebnahme des Gerätes über eine Schaltstufe 7 den Schalter 4, der z. B. mit dem negativen Pol — VCC der Versorgungsspannungsquelle verbunden ist. Eine an den Schalter 4 gekoppelte Steuerstufe 8 betätigt den Schalter 5, der mit dem positiven Pol + VCC der Versorgungsspannungequelle verbunden ist. Im ungestörten Betrieb wird beim Einschalten des Gerätes zunächst der Schalter 4 geschlossen, der wiederum den Schalter 5 durchschaltet, so daß die Vortreiberstufe 2 ihre Betriebsspannung erhält und der NP-Verstärker arbeitet. Tritt nun eine Störung auf, sei es durch eine längere Überlastung der Endstufe 1 infolge zu geringer Lastimpedanz oder durch eine unzulässig hohe Gleichspannung am Lautsprecher 3, wird über die Sensorschaltung 9 und 10 eine Schaltstufe 7 betätigt, die äußerst schnell den Schalter 4 öffnet. Diese bewirkt über die Steuerstufe 8 eine unmittelbare Öffnung des Schalters 5. Dadurch ist die Vortreiberstufe 2 von der Versorgungsspannungsquelle abgetrennt, die Endstufe 1 wird nicht mehr angesteuert, eine übermässige Erwärmung tritt nicht ein. Die Schalter 4 und 5 in der genannten Reihenfolge können erst dann wieder schließen, wenn der Störfall beseitigt ist. Wenn der Schalter 4 geöffnet ist, bleibt auch der Schalter 5 geöffnet. Die Endstufe 1 ist nicht betriebsbereit.

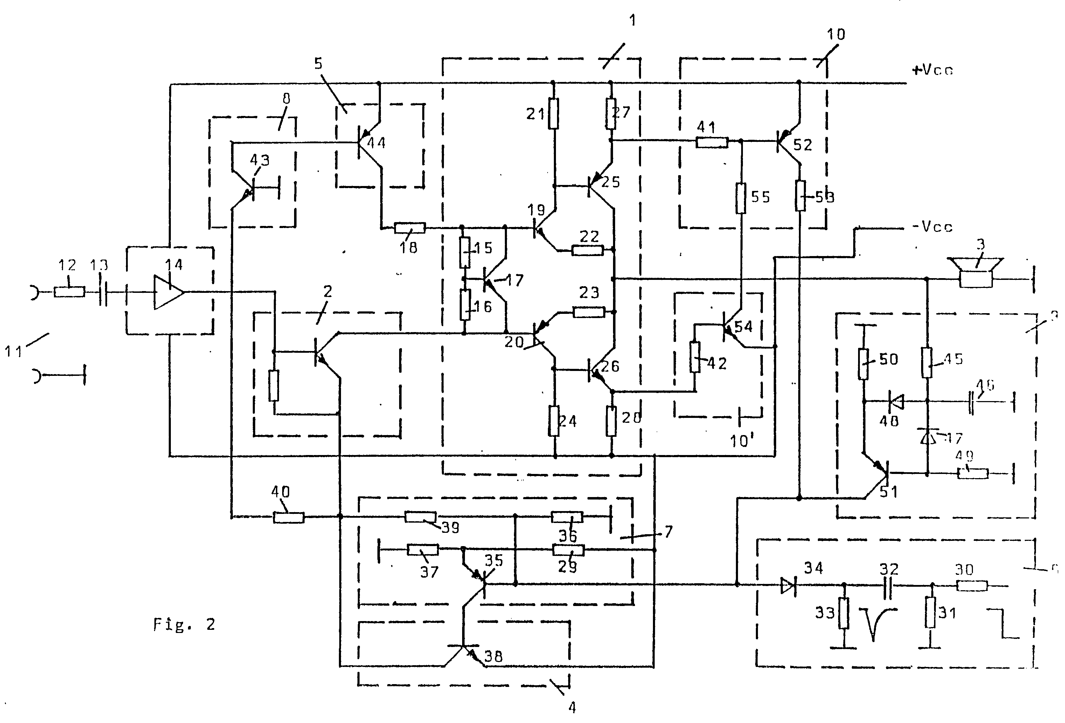

Mit Hilfe der Figur 2 wird nachstehend die Wirkungsweise einer detaillierten Schaltungsanordnung zur Lösung der der Erfindung zugrunde liegenden Aufgabe beschrieben.

Das Eingangssignal gelangt an den Eingang 11 über den Widerstand 12 und den Kondensator 13 an eine Vorstufe 14, die zwischen die Betriebsspannungsquelle + VCC und — VCC geschaltet ist. Das Ausgangssignal der Vorstufe 14 wird über die Vorteiberstufe 2 an die Endstufe 1 in bekannter Weise angeschaltet. Die Endstufe besteht aus der Treiberstufe 19, 20, 21, 22, 23 und 24, die an die Endstufentransistoren 25 und 26 angeschaltet ist. Die Basen der Treibertransistoren 19 und 20 sind über eine Schaltung zur Stabilisierung des Puhestroms mit Hilfe der Widerstände 15, 16 und des Transistors 17 miteinander verbunden. Die Stabilisierungsschaltung liegt über dem Widerstand 18 und über den elektronischen Schalter 5 an dem positiven Pol + VCC der Versorgungsspannungsquelle. Der Emitter des Endstufentransistors 25 ist über einen Widerstand 27 mit der positiven Versorgungsspannung + VCC verbunden. Der Emitter der Vortreiberstufe 2 ist über den elektronischen Schalter 4 an den negativen Pol — VCC der Betriebsspannungsquelle angekoppelt. Der Emitter des Endstufentransistors 26 ist über den Widerstand 28 mit dem negativen Pol — VCC der Versorgungsspannungsquelle verbunden. An die Kollektoren der Endstufentransistoren 25 und 26 ist die Lastimpedanz in Form eines Lautsprechers 3 gegen Messe geschaltet.

Beim Einschalten des Gerätes gelangt aus dem nichtdargestellten Netzteil eine negative Spannung über den Spannungsteiler 30/31 an den Kondensator 32 und den Widerstand 33. Durch die Differenzierung des Gleichspannungssprungs entsteht an Widerstand 33 ein negativer Impuls. Dieser gelangt weiter über die Diode 34 an die Basis eines Transistors 35 dessen Emitter über einen Widerstand 37 nach Masse und einen Widerstand 28 nach — VCC geschaltet ist, und dessen Kollektor mit der Basis eines Transistors 38 verbunden ist, der den elektronischen Schalter 4 bildet. Der negative Impuls schaltet den Transistor 35 ein, der den Basisstrom für den Transistor 38 liefert, so daß dieser durchschaltet und damit die negative Versorgungsspannung — VCC an die Vorstreiberstufe 2 schaltet. Der Transistor 35 bleibt durch die Rückkopplung über den Widerstand 39 durchgeschaltet. Sobald die negative Versorgungsspannung — VCC an den Kollektor des Transistors 38 gelangt, wird der Transistor 43 aktiviert, da seine Basis an Masse liegt. Der Widerstand 40 bestimmt die Größe des Kollektorstromes des Transistors 48, der den Basisstrom für den Transistor 44 des elektronischen Schalters 5 bildet. Dieser legt schießlich die positive Versorgungsspannung + VCC an die Vortreiberstufe 2. Hiermit ist die Endstufe 1 voll wirksam.

Wenn nun ein Störfall eintritt, sollen die elektronischen Schaltstufen 4 und 5 unmittelbar reagieren und die Vortreiberstufe 2 von der Versorgungsspannung abschalten. Ändert sich das Gleichspannungspotential am Ausgang der Endstufe 1 und verschiebt sich somit das Brückengleichgewicht, gelangt diese Information über den Widerstand 45 an einen Kondensator 46. Positive Änderungen gelangen über die Diode 48 auf den Emitter eines Transistors 51 der mit seiner Basis über den Widerstand 49 auf Massepotential liegt. Negative Änderungen gelangen über die Diode 47 auf die Basis des Transistors 51, so daß in beiden Fällen dieser durchgeschaltet wird. Der Emitter des Transistors 51 liegt über dem Widerstand 50 auf Massepotential. Das Durchschalten des Transistors 51 bewirkt ein sofortiges Sperren des Transistors 35 und damit Öffnen des Schalters 4, da der Transistor 38 gesperrt wird. Als Folge hiervon wird auch sofort der Schalter 5 geöffnet, da die negative Betriebsspannung — VCC fehlt.

Wenn die Endstufe 1 einen zu großen Strom aufnimmt, wird dies über die Widerstände 27 bzw. 28 sowie Schutzwiderstände 41, 42 den Basen der Transistoren 52 bzw. 54 mitgeteilt, die in diesem Fall durchschalten. Der Transistor 52 schaltet die positive Betriebsspannung + VCC über den Widerstand 53 auf die Basis des Transistors 35, wodurch der Transistor 38 unmittelbar gesperrt wird. Wenn der Strom durch den Widerstand 28 einen Grenzwert übersteigt, schaltet der Transistor 54 durch und legt die Basis des Transistor 52 über einen Schutzwiderstand 55 an den negativen Pol — VCC, worauf der Transistor 52 ebenfalls durchschaltet und die Sperrung des Transistors 35 bewirkt.

## Patentansprüche

1. Überlastungsschutzschaltung für einen Niederfrequenzverstärker mit einer Eingangsstufe (14), einer Vortreiberstufe (2) im A-Betrieb, einer dieser unmittelbar nachgeschalteten Treiber- und Endstufe (1) im Gegentakt-Betrieb und einer an diese galvanisch angekoppelten Lastimpedanz (3), wobei die Treiber- und Endstufen komplementär an eine positive und eine negative Betriebsspannung (± Vcc) angeschlossen sind, sowie mit einer eine Störung detektierenden Sensorschaltung (9, 10, 10'), dadurch gekennzeichnet, daß in der positiven und negativen Versorgungsspannungsleitung für die Vortreiberstufe (2) je ein Schalter (4, 5) vorgesehen ist, der von der Sensorschaltung (9, 10, 10') gesteuert die Betriebsspannungen (+ Vcc, — Vcc) nur für die Vortreiberstufe (2) abschaltet.

2. Niederfrequenzverstärker nach Anspruch 1, dadurch gekennzeichnet, daß die Schalter (4, 5) elektronische Schalter sind, die im ungestörten Betrieb des Niederfrequenzverstärkers mit hoher Sättigung betrieben werden.

3. Niederfrequenzverstärker nach Anspruch 1, dadurch gekennzeichnet, daß im Normalbetrieb der zweite Schalter (5) in Abhängigkeit vom Schaltzustand des ersten Schalters (4) betätigt wird.

4. Niederfrequenzverstärker nach Anspruch 1, dadurch gekennzeichnet, daß im Störfall beide Schalter (4, 5) gleichzeitig betätigt werden.

5. Niederfrequenzverstärker nach Anspruch 1, dadurch gekennzeichnet, daß die Schalter (4, 5) beim Einschalten des Niederfrequenzverstärkers durch einen Impuls betätigt werden und der erste Schalter (4) eine Selbsthalteschaltung besitzt.

6. Niederfrequenzverstärker nach Anspruch 1, dadurch gekennzeichnet, daß die Sensorschaltung (10, 10') ein Überschreiten eines vorgegebenen Spitzenstroms in der Endstufe (1) feststellt.

7. Niederfrequenzverstärker nach Anspruch 1, dadurch gekennzeichnet, daß die Sensorschaltung (9) eine unzulässig große Gleichspannung an der Lastimpedanz (3) feststellt.

## Claims

1. An overload protection circuit for a low frequency amplifier with an input stage (14), a pre-driver stage (2) in the class A-operation, a driver- and output stage (1) connected directly downstream of the predriver stage in push-pull operation and a load impedance (3) coupled to the latter galvanically, wherein the driver- and output stages are connected complementarily to a positive and a negative operational voltage (± Vcc) and having a sensor circuit (9, 10, 10') detecting disturbance, characterized in that there is provided in each of the positive and negative supply line for the pre-driver stage (2) a switch (4, 5), which, controlled by the sensor circuit (9, 10, 10'), disconnects the operational voltages (+ Vcc, — Vcc) only for the predriver stage (2).

2. A low frequency amplifier according to Claim 1, characterized in that the switches (4, 5) are electronic switches which are operated in the undisturbed operation of the low frequency amplifier with high saturation.

3. A low frequency amplifier according to Claim 1, characterized in that in normal operation the second switch (5) is actuated as a function of the switching state of the first switch (4).

4. A low frequency amplifier according to Claim 1, characterized in that in the case of disturbance both switches (4, 5) are actuated simultaneously.

5. A low frequency amplifier according to Claim 1, characterized in that when the low frequency amplifier is connected, the switches (4, 5) are actuated by a pulse and the first switch (4) has a self-holding circuit.

6. A low frequency amplifier according to Claim 1, characterized in that the sensor circuit (10, 10') determines when a predetermined peak current is exceeded in the output stage (1).

7. A low frequency amplifier according to Claim 1, characterized in that the sensor circuit (9) determines an inadmissibly large direct voltage at the load impedance (3).


**Revendications**

1. Circuit de protection contre les surcharges pour un amplificateur à basse fréquence comportant un étage d'entrée (14), un étage d'attaque amont (2) fonctionnant dans la mode A, un étage final d'attaque (1) branché directement en aval de l'étage précédent fonctionnant dans le mode push-pull, et une impédance de charge (11) raccordée galvaniquement à cet étage final, l'étage d'attaque amont et l'étage d'attaque final étant raccordés de façon complémentaire à une tension de service positive et à une tension de service négative (+ Vcc), et comportant un circuit de détection (9, 10, 10') détectant une perturbation, caractérisé par le fait que dans la ligne de tension d'alimentation positive ou négative prévue pour l'étage d'attaque amont (2), il est prévu des interrupteurs respectifs (4, 5), qui, sous la commande du circuit de détection (9, 10, 10') débranchent les tensions de service (+ Vcc, — Vcc) uniquement pour l'étage d'attaque amont (2).

2. Amplificateur à basse fréquence suivant la revendication 1, caractérisé par le fait que les interrupteurs (4, 5) sont des interrupteurs électroniques, qui, dans le cas d'un fonctionnement non perturbé de l'amplificateur à basse fréquence, fonctionnent avec une saturation élevée.

3. Amplificateur à basse fréquence suivant la revendication 1, caractérisé par le fait que, dans le cas du fonctionnement normal, le second interrupteur (5) est commandé en fonction de l'état de commutation du premier interrupteur (4).

4. Amplificateur à basse fréquence suivant la revendication 1, caractérisé par le fait que dans le cas d'une perturbation, les deux interrupteurs (4, 5) sont actionnés simultanément.

5. Amplificateur à basse fréquence suivant la revendication 1, caractérisé par le fait que, lors du branchement de l'amplificateur à basse fréquence, les interrupteurs (4, 5) sont actionnés par une impulsion et que le premier interrupteur (4) possède un circuit d'auto-maintien.

6. Amplificateur à basse fréquence suivant la revendication 1, caractérisé par le fait que le circuit de détection (10, 10') détermine un dépassement d'un courant maximum prédéterminé dans l'étage final (1).

7. Amplificateur à basse fréquence suivant la revendication 1, caractérisé par le fait que le circuit de détection (9) détermine une tension continue élevée inadmissible au niveau de l'impédance de charge (3).

Fig. 1

Fig. 2